(19) Europäisches Patentamt
European Patent Office
Office européen des brevets

(11) Numéro de publication : **0 165 111 B1**

(12) **FASCICULE DE BREVET EUROPÉEN**

(45) Date de publication du fascicule du brevet : **27.07.88**

(51) Int. Cl.$^4$ : **H 01 B 1/12**, H 01 L 29/28

(21) Numéro de dépôt : **85400877.8**

(22) Date de dépôt : **06.05.85**

(54) **Films conducteurs de l'électricité comprenant au moins une couche monomoléculaire d'un complexe organique à transfert de charge et leur procédé de fabrication.**

(30) Priorité : **10.05.84 FR 8407214**

(43) Date de publication de la demande : **18.12.85 Bulletin 85/51**

(45) Mention de la délivrance du brevet : **27.07.88 Bulletin 88/30**

(84) Etats contractants désignés : **DE GB NL**

(56) Documents cités :
**WO-A-83 /031 65**
**FR-A- 2 321 770**

(73) Titulaire : **COMMISSARIAT A L'ENERGIE ATOMIQUE**
**31/33, rue de la Fédération**
**F-75015 Paris (FR)**

(72) Inventeur : **Barraud, André**
**4, rue des Closeaux**
**F-91440 Bures Sur Yvette (FR)**
Inventeur : **Ruaudel, Annie**
**14, Allée des Frondaisons**
**F-91370 Verrieres Le Buisson (FR)**
Inventeur : **Vandevyver, Michel**
**14, rue du Général de Gaulle**
**F-92290 Chatenay Malabry (FR)**

(74) Mandataire : **Mongrédien, André et al**
**c/o BREVATOME 25, rue de Ponthieu**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

EP 0 165 111 B1

## Description

La présente invention a pour objet des films conducteurs de l'électricité comprenant au moins une couche monomoléculaire d'un complexe organique à transfert de charge et leur procédé de fabrication.

On rappelle que les complexes organiques à transfert de charge sont formés par l'association de deux molécules dont l'une, A, agit comme accepteur d'électrons et, l'autre D, agit comme donneur d'électrons.

On peut représenter cette réaction de la façon suivante :

$$mA + nD \longrightarrow A_m^{-\rho}D_n^{+\rho}$$

m et n représentant les nombres respectifs de molécules et ρ le transfert de charge correspondant à la proportion d'électrons transférés. Lorsque m = n, on a une stœchiométrie simple et lorsque m ≠ n on a une stœchiométrie complexe.

Lorsque $\rho \simeq 0$, le complexe est un complexe moléculaire à état fondamental neutre.

Lorsque $\rho = 1$, c'est un vrai composé ionique avec une charge électrique par molécule D ou A, et lorsque $\rho < 1$ il y a moins de charge électrique que de molécules présentes. On a ainsi un composé à valence mixte, condition nécessaire pour obtenir un conducteur organique. On peut alors distinguer :

1. Les vrais complexes à transfert de charge dans lesquels il y a transfert d'un électron du donneur à l'accepteur ; ces électrons célibataires se trouvent alors sur des orbitales π (complexes π-π) ; et

2. Les sels d'ions radicalaires dans lesquels un seul des ions est radicalaire, le contre-ion étant diamagnétique.

Des complexes de ce type sont en particulier décrits dans : Annales de Physique, 1976, tome I, n° 4-5, pages 145-256 et dans Journal de Chimie-Physique, 1982, 79, n° 4.

Ces complexes fabriqués, soit chimiquement, soit électrochimiquement, cristallisent en rangées de molécules alignées, ce qui donne une conduction unidimensionnelle et ces rangées sont entourées de toutes parts par des rangées parallèles identiques, dont la proximité immédiate induit par couplage une conduction « en travers », c'est-à-dire une conduction perpendiculaire à la direction privilégiée. Ces complexes conducteurs ou semiconducteurs de l'électricité présentent donc un caractère unidimensionnel dominant, mélangé de tridimensionnel.

Ces complexes sont obtenus sous la forme d'aiguilles ou de cristaux. Toutefois, il serait d'un grand intérêt de les avoir sous la forme de films conducteurs homogènes, présentant en particulier des plans conducteurs très minces isolés entre eux, comme cela pourrait être le cas dans des couches monomoléculaires.

En effet, pour la réalisation de certains composants électroniques, des structures de ce type sont intéressantes en raison de leur forte anisotropie de conduction.

Cependant, jusqu'à présent, il a été impossible d'obtenir des films conducteurs de ce type comportant des couches monomoléculaires de complexes à transfert de charge.

En effet, pour pouvoir déposer des couches monomoléculaires par la méthode connue de Langmuir Blodgett décrite dans le Journal of Am. Chem. Soc. volume 57(1935), pages 1007 à 1010, il est tout d'abord nécessaire que le complexe à transfert de charge soit constitué par une molécule amphiphile ou « amphipathique », c'est-à-dire une molécule organique possédant une partie hydrophobe, soit une partie ayant une répulsion pour les liquides polaires tels que l'eau, et une partie hydrophile, soit une partie ayant une affinité pour les liquides polaires tels que l'eau. En effet, lorsque l'on introduit de telles molécules amphiphiles sur la surface d'un liquide tel que l'eau, les molécules s'étalent à la surface du liquide et elles s'orientent de façon que leur partie hydrophile plonge dans l'eau tandis que leur partie hydrophobe, généralement constituée par une chaîne hydrocarbonée, tend à s'en écarter de sorte que l'axe de la chaîne devient perpendiculaire à la surface de l'eau. Si les forces de cohésion entre molécules sont suffisantes, ces molécules restent groupées et limitent leur étalement à un film monomoléculaire continu ayant sensiblement l'épaisseur d'une molécule, ce qui correspond à un film de Langmuir. De tels films peuvent être manipulés sur la surface de l'eau, puis déposés sur un support solide après avoir été comprimés sous une pression superficielle appropriée. Lorsque l'on introduit ensuite un support dans la cuve, on dépose sur ce support solide la couche monomoléculaire présente sur la surface de l'eau. De même, lorsque l'on extrait un support préalablement immergé dans la cuve, on dépose sur le support une couche monomoléculaire et l'orientation des molécules par rapport au support est différente selon que le dépôt a eu lieu par introduction du support dans la cuve ou par extraction du support de la cuve. Or, ce procédé, s'il a été utilisé dans le procédé décrit dans FR-A-2321770 pour fabriquer des films monomoléculaires isolants ou semi-conducteurs à partir de molécules amphiphiles, ne peut s'appliquer aux complexes à transfert de charge connus actuellement car ceux-ci ne sont pas formés de molécules « amphiphiles »

Toutefois, en substituant l'une des molécules du complexe par une chaîne hydrocarbonée hydrophobe, on peut obtenir des complexes amphiphiles. Cependant, les essais effectués jusqu'à présent pour déposer des couches monomoléculaires de complexes à transfert de charge, amphiphiles ainsi substitués n'ont pas permis d'obtenir directement un film conducteur. En effet, les complexes à transfert

de charge ne manifestent des propriétés de conduction électrique qu'à certaines conditions ; il faut en particulier que les molécules soient hautement organisées d'une manière spécifique afin de permettre à la fois le recouvrement des orbitales conductrices et le transfert de charge partiel. Cette organisation existe dans les complexes sous forme de poudres, mais la nécessité de dissoudre ces complexes dans une solution pour former un film de Langmuir détruit cette organisation. Il en est d'ailleurs de même lorsque l'on utilise des procédés de dépôt de films par évaporation, sublimation, mise en solution ou tout procédé nécessitant une phase de séparation des molécules les unes des autres.

La présente invention a précisément pour objet des films conducteurs de l'électricité comprenant au moins une couche monomoléculaire de molécules amphiphiles d'un complexe organique à transfert de charge et un procédé de fabrication des films qui permet d'obtenir un film conducteur, bien que l'on dépose les couches monomoléculaires par la méthode de Langmuir Blodgett.

Le film conducteur de l'électricité selon l'invention, comprend au moins une couche monomoléculaire de molécules amphiphiles d'un complexe organique à transfert de charge comportant au moins un groupe accepteur d'électrons et au moins un groupe donneur d'électrons, le groupe accepteur et/ou le groupe donneur d'électrons comportant au moins une chaîne hydrocarbonée de 16 à 30 atomes de carbone et les groupes accepteurs et/ou donneurs d'électrons étant organisés de façon telle que deux groupes voisins de même nature, soit donneurs d'électrons, soit accepteurs d'électrons, puissent être suffisamment couplés dans le plan de la couche pour échanger un électron et assurer une conduction électrique dans ce plan.

Les films décrits ci-dessus présentent ainsi une organisation entre groupes accepteurs et/ou groupes donneurs d'électrons du complexe, qui permet d'obtenir une conduction électrique dans le plan de la couche.

Selon un premier mode de réalisation du film de l'invention, celui-ci comprend plusieurs couches monomoléculaires superposées de molécules amphiphiles d'un complexe à transfert de charge, l'ensemble desdites couches déterminant dans le film des plans hydrophiles conducteurs de l'électricité séparés les uns des autres par les chaînes hydrocarbonées hydrophobes isolantes du complexe.

Selon un second mode de réalisation du film de l'invention, celui-ci comprend plusieurs couches monomoléculaires, superposées, comprenant au moins une couche monomoléculaire de molécules amphiphiles d'un complexe à transfert de charge conducteur de l'électricité et au moins une couche monomoléculaire d'un composé amphiphile électriquement isolant, les différentes couches monomoléculaires étant disposées dans le film de façon telle qu'au moins deux plans conducteurs formés dans deux couches monomoléculaires du complexe organique à transfert de charge conducteur soient séparés l'un de l'autre par une ou plusieurs couches monomoléculaires de molécules amphiphiles isolantes.

Dans ces deux modes de réalisation du film de l'invention, on a des plans électriquement actifs séparés par de la matière électriquement inerte qui peut être constituée soit par la partie non conductrice, par exemple par les chaînes hydrophobes, des molécules du complexe, soit par des couches monomoléculaires d'un composé organique isolant. Cette organisation confère à ces films conducteurs des propriétés d'anisotropie, c'est-à-dire une conduction plus grande dans le plan du film que suivant la normale au film. En effet, le fait d'introduire un ou plusieurs plans isolants entre les plans conducteurs du film confère à celui-ci un caractère partiellement bidimensionnel et non tridimensionnel. L'importance de cette bidimensionnalité par rapport à l'unidimensionnalité de base dépend d'ailleurs de la structure des empilements conducteurs dans le plan hydrophile et l'on sait que la dimensionnalité d'un conducteur électrique détermine une partie de ses propriétés (transition de Peierls, supraconductivité, magnétisme etc.). Dans le cas où l'on dispose entre les couches monomoléculaires des couches monomoléculaires d'un composé isolant, on renforce l'anisotropie de conduction car on obtient ainsi des plans simples ou doubles conducteurs séparés par au moins un plan double isolant.

On précise que l'on entend par plan « simple » conducteur, le plan délimité par les parties hydrophiles d'une seule couche monomoléculaire. On entend par plan « double » conducteur, le plan conducteur obtenu à l'interface de deux couches monomoléculaires dans lesquelles les extrémités hydrophiles d'une couche sont en contact avec les extrémités hydrophiles de la couche suivante.

Dans ces deux modes de réalisation du film de l'invention, on peut aussi réaliser les différentes couches monomoléculaires conductrices de l'électricité à partir d'au moins deux complexes à transfert de charge différents.

Ainsi, on peut utiliser n complexes et obtenir des structures de films comportant une ou plusieurs couches d'un premier complexe à transfert de charge, une ou plusieurs couches d'un second complexe à transfert de charge et ainsi de suite jusqu'au nième complexe à transfert de charge. On peut de plus organiser les couches entre elles en les intercalant de façon appropriée.

Lorsque l'on utilise deux complexes à transfert de charge différents, le film de l'invention peut comprendre :

a) au moins une couche monomoléculaire de molécules amphiphiles d'un premier complexe à transfert de charge conducteur de l'électricité,

b) au moins une couche monomoléculaire de molécules amphiphiles d'un second complexe à transfert de charge conducteur de l'électricité, et

c) au moins une couche monomoléculaire d'un composé amphiphile électriquement isolant,

les différentes couches monomoléculaires étant disposées dans le film de façon telle qu'au moins deux plans conducteurs formés dans les couches monomoléculaires du premier complexe à transfert de charge conducteur et/ou dans les couches monomoléculaires du second complexe organique à transfert de charge conducteur soient séparés l'un de l'autre par une ou plusieurs couches monomoléculaires de molécules amphiphiles isolantes.

Des structures de film de ce type sont particulièrement intéressantes car en choisissant de façon appropriée la nature, le nombre et la répartition des différentes couches, on peut faire remplir au film des fonctions spécifiques comme le font les redresseurs, les diodes-tunnels et les photoconducteurs en électronique.

Dans les films conducteurs de l'invention, les complexes organiques à transfert de charge utilisés sont avantageusement des complexes répondant à la formule :

$$DA_xX_y$$

dans laquelle D représente un groupe organique donneur d'électrons, A représente un groupe organique accepteur d'électrons, X représente un accepteur d'électrons non amphiphile choisi parmi les acides de Lewis, x est un nombre supérieur à 0 et y est égal à 0 ou est un nombre supérieur à 0, l'un au moins des groupes D et A étant amphiphile et comportant un substituant hydrocarboné saturé ou insaturé d'au moins 16 atomes de carbone.

Généralement, x et y ont des valeurs pouvant aller jusqu'à 20, et le substituant hydrocarboné a au plus 30 atomes de carbone.

Dans ce complexe, le groupe X peut représenter $I^-$, $PF_6$, $ClO_4^-$, $BF_4^-$, $ReO_4^-$, $IO_4^-$, $FSO_3^-$, $AsF_6^-$, $AsF_4^-$, $Br^-$, $Cl^-$, et $MnCl_6^-$ ; de préférence, X représente $I^-$.

Dans cette formule, le groupe organique donneur d'électrons D peut représenter une base aliphatique, aromatique ou hétérocyclique, comportant de préférence au moins une chaîne hydrocarbonée, saturée ou insaturée, ayant de 16 à 30 atomes de carbone.

Les bases aliphatiques susceptibles d'être utilisées peuvent être, en particulier, des groupes ammonium quaternaire tels que des tétraalkylammonium.

Les bases aromatiques susceptibles d'être utilisées peuvent être constituées par des groupes ammonium quaternaire dérivés de l'aniline ou de dérivés substitués de l'aniline.

Les bases hétérocycliques susceptibles d'être utilisées peuvent être constituées par des groupements ammonium quarternaire dérivés des pyridines, des pipéridines, des bipipéridines, des benzopyridines, par exemple des quinoléines et des isoquinoléines, des acridines, des phénazines, et des phénanthrolines.

La base hétérocyclique peut aussi comporter plusieurs hétéroatomes de nature différente, par exemple des atomes d'azote et de soufre, comme les N-alkylbenzothiazoles et leurs dérivés substitués, et les N-alkyl indoléniniumtriméthinecyanines et leurs dérivés substitués.

Le groupe organique accepteur d'électrons A peut être un des groupes entrant généralement dans la réalisation de complexes à transfert de charge, comme le tétracyanoéthylène (TCNE), l'hexacyanobutadiène (HCBD), le 1,2,4,5-tétracyanobenzène (TCNB), le 7,7,8,8-tétracyanoquinodiméthane (TCNQ) et ses dérivés subsitués, le tétracyanodiquinodiméthane (TCNDQ), le benzotétracyanoquinodiméthane (benzo-TCNQ), le 2,3,5,6,-tétrachloro-p-benzoquinone (CA), le trinitrobenzène (TNB), le tétranaphtoquinodiméthane (TNAP), le thiophènetétracyanoquinodiméthane (thiophène-TCNQ), le sélénophène-tétracyanoquinodiméthane (sélénophène-TCNQ), et le tétracyanoquinoquinazolinoquinazoline (TCQQ).

A titre d'exemple de complexes à transfert de charge utilisés dans les films conducteurs de l'invention, on peut citer les alkylpyridinium-tétracyanoquinodiméthane et les alkylpyridinium-tétracyanoquinodiméthane-iode.

Lorsque le film comprend des couches monomoléculaires d'un premier complexe et des couches monomoléculaires d'un second complexe, le premier complexe organique à transfert de charge est un alkylpyridiniumtétracyanoquinodiméthane, et le second complexe à transfert de charge conducteur de l'électricité est un complexe de formule $DA_xX_y$ dans laquelle D représente un alkylpyridinium, A représente le tétracyanoquinodiméthane (TCNQ) et X représente l'iode, avec x supérieur à 0 et y supérieur à 0. Généralement, les complexes à transfert de charge conducteurs de l'électricité sont des complexes de formule $DA_xX_y$ dans laquelle D représente un alkylpyridinium, A représente le tétracyanoquinodiméthane (TCNQ) et X représente l'iode, avec $1 < x \leq 2$ lorsque $y = 0$.

Lorsque les films comportent des couches monomoléculaires d'un composé organique isolant, celui-ci peut être un acide gras tel que l'acide béhénique.

L'invention a également pour objet un procédé de préparation de films conducteurs comportant des couches monomoléculaires de complexes organiques à transfert de charge, qui utilise la technique de Langmuir Blodgett pour la réalisation des couches monomoléculaires, mais qui implique soit certaines conditions de dépôt des couches monomoléculaires, soit des traitements thermiques ou chimiques supplémentaires, pour former un film conducteur à partir de ces couches monomoléculaires.

Ainsi, selon un premier mode de mise en œuvre du procédé de préparation d'un film conducteur selon l'invention, ce procédé comprend les étapes suivantes :

a) déposer sur la surface d'un liquide polaire une solution d'un complexe à transfert de charge

amphiphile conducteur de l'électricité de façon à former sur la surface dudit liquide une couche monomoléculaire,

b) comprimer la couche monomoléculaire ainsi formée à une pression supérieure à celle qui correspond à une transition de phase bidimensionnelle dudit complexe à transfert de charge, et

c) transférer la couche monomoléculaire ainsi comprimée sur un support.

Lorsque l'on veut déposer plusieurs couches sur le même support, on opère de la même façon et l'on répète ces opérations.

Dans ce premier mode de réalisation du procédé de l'invention, il est par ailleurs avantageux de réaliser le dépôt de la couche en montant lentement le support lorsque celui-ci est immergé dans le liquide ou en le redescendant aussi vite que l'on peut lorsque l'on réalise le dépôt par descente du substrat dans le liquide.

Ce premier mode de mise en œuvre du procédé permet ainsi d'obtenir directement des films conducteurs en jouant sur les conditions utilisées pour le dépôt de la couche monomoléculaire sur le support. En effet, lorsque l'on réalise le dépôt d'une couche d'octadécylpyridinium-TCNQ de façon classique en comprimant la couche à une pression de 0 à 18 mN/m ce qui est le domaine de stabilité habituelle de la couche sous sa forme naturelle, on obtient un film isolant. En revanche, en réalisant la compression à une valeur supérieure à 20 mN/m, on opère au-delà d'une transition de phase bidimensionnelle du complexe, ce qui permet une réorganisation de la couche et lui confère des propriétés conductrices.

On peut aussi fabriquer les films conducteurs de l'invention en réalisant le dépôt des couches monomoléculaires dans des conditions habituelles en soumettant ensuite le film déposé à des traitements thermiques et/ou chimiques. Ainsi, selon un second mode de mise en œuvre du procédé de l'invention, celui-ci comprend les étapes suivantes :

a) déposer sur un support isolant par la méthode de Langmuir Blodgett une ou plusieurs couches monomoléculaires d'un complexe organique à transfert de charge non conducteur de l'électricité, et

b) soumettre ensuite la ou les couches monomoléculaires ainsi déposées à un traitement thermique ou chimique pour les rendre conductrices de l'électricité.

Le traitement chimique peut consister à diffuser de l'iode dans les couches monomoléculaires déposées sur le support. Le traitement thermique peut consister en un chauffage des couches ainsi déposées à une température inférieure à la température de fusion du complexe organique à transfert de charge.

Ce procédé peut être utilisé en particulier pour former un film conducteur de docosylpyridinium tétracyanoquinodiméthane par diffusion d'iode dans les couches déposées.

Selon un troisième mode de mise en œuvre du procédé de l'invention, on part de molécules amphiphiles d'un complexe organique à transfert de charge peut ou non conducteur de l'électricité et on fait réagir ce complexe avec un composé organique amphiphile pour rendre le complexe à transfert de charge conducteur de l'électricité.

Dans ce troisième mode de mise en œuvre du procédé, on dépose sur un support des couches monomoléculaires de molécules amphiphiles d'un complexe organique à transfert de charge non conducteur de l'électricité et d'un composé organique amphiphile capable de réagir avec le complexe à transfert de charge pour le rendre conducteur de l'électricité.

Le dépôt des couches monomoléculaires peut être réalisé en déposant alternativement sur le support une couche monomoléculaire du complexe organique à transfert de charge non conducteur et une couche monomoléculaire du composé amphiphile.

Dans ce cas, on réalise de préférence le dépôt des couches alternées de façon telle que les parties hydrophiles du complexe organique à transfert de charge soient en contact avec les parties hydrophiles du composé amphiphile ajouté afin de favoriser la réaction entre le complexe à transfert de charge et ce composé.

Dans certains cas, on peut de plus soumettre l'ensemble des couches déposées à des traitements chimique et/ou thermique tels que ceux évoqués ci-dessus pour augmenter l'efficacité de la réaction.

Dans ce troisième mode de mise en œuvre du procédé de l'invention, on peut aussi former directement sur la surface d'un liquide une couche monomoléculaire comportant le complexe organique à transfert de charge amphiphile non conducteur et le composé amphiphile, puis déposer cette couche sur un support.

Ce mode de mise en œuvre du procédé de l'invention est particulièrement adapté à la réalisation de couches monomoléculaires formées d'un complexe à transfert de charge de formule $DA_xX_y$.

Dans ce cas, le composé amphiphile ajouté est généralement un composé de X et D, par exemple un iodure d'alkylpyridinium, et le complexe est un composé de D et A, par exemple un alkylpyridinium-tétracyanoquinodiméthane.

Lorsque l'on veut réaliser selon l'invention un film conducteur comportant des couches de complexes organiques conducteurs et des couches de composés isolants, on dépose les couches monomoléculaires de composés isolants, en utilisant également la technique de Langmuir Blodgett. Il en est de même lorsque l'on veut déposer des couches monomoléculaires d'un premier complexe à transfert de charge et des couches monomoléculaires d'un second complexe à transfert de charge.

Les complexes à transfert de charge de l'invention peuvent être préparés par des procédés

classiques tels que celui décrit par L.R. Melby et al dans Journ. of Am. Chem. Soc. vol. 84 (1962), p. 3374-3387.

Les complexes de formule $DA_x$ avec D représentant un groupe organique donneur d'électrons et A un groupe organique accepteur d'électrons, sont préparés en faisant réagir un halogénure du groupe organique donneur d'électrons D avec un sel du groupe accepteur d'électrons A, par exemple l'iodure de D avec le sel de lithium de A. On peut aussi faire réagir le complexe ainsi obtenu avec un excès du groupe accepteur d'électrons A, ce qui généralement permet l'obtention d'un complexe organique conducteur de l'électricité. Les complexes de formule $DA_xX_y$ peuvent être obtenus en faisant réagir un composé de D et X sur le groupe organique accepteur d'électrons A.

Les composés de départ utilisés pour la préparation de ces complexes, par exemple les bases organiques substituées comportant une longue chaîne hydrocarbonée sont obtenus par des procédés classiques. De même, les groupements accepteurs d'électrons A sont des composés connus qui sont obtenus également par des procédés classiques.

Les supports utilisés dans l'invention pour le dépôt des couches monomoléculaires sont des supports rigides présentant une affinité suffisante vis-à-vis des molécules à déposer. Ils peuvent être réalisés par exemple en verre, en quartz, en $CaF_2$, en matière plastique, ou en métal ou alliage métallique tel que l'aluminium, l'acier inoxydable, le nickel, le cuivre, etc...

Les exemples suivants sont donnés bien entendu à titre non limitatif pour illustrer l'invention.

## Exemple 1

Dans cet exemple, on utilise le premier mode de mise en œuvre du procédé pour préparer un film constitué de couches monomoléculaires d'octadécylpyridiniumtétracyanoquinodiméthane (ODP-TCNQ).

On synthétise tout d'abord le complexe à transfert de charge (ODP-TCNQ) en faisant réagir à chaud dans une solution alcoolique, l'iodure d'octadécylpyridinium avec le sel de lithium du tétracyanoquinodiméthane. On obtient ainsi, après refroidissement, une poudre du complexe que l'on lave et que l'on recristallise. Ce complexe est ensuite redissous dans l'acétonitrile avec un équivalent de TCNQ. Un complexe noir cristallise à froid. Il est conducteur de l'électricité.

On prépare alors une solution contenant $5.10^{-4}$ $mol.l^{-1}$ de ce complexe dans du chloroforme et l'on disperse cette solution sur la surface de l'eau d'une cuve de Langmuir. On forme ainsi une couche monomoléculaire que l'on comprime à une pression de 26 $mN.m^{-1}$ et on la transfère alors sur un support isolant en $CaF_2$ par la méthode de Langmuir Blodgett. On recommence plusieurs fois l'opération afin d'obtenir sur le support isolant un film comportant dix neuf couches monomoléculaires superposées, ce qui détermine neuf plans hydrophiles doubles conducteurs de l'électricité et un plan hydrophile simple conducteur de l'électricité.

Le film obtenu est conducteur de l'électricité et présente une résistivité de 8 ohms.cm à 20 °C. Il est bleu et son spectre infrarouge est celui d'un matériau semiconducteur.

En revanche, si on réalise le dépôt des couches après les avoir comprimées à une pression de 18 $mN.m^{-1}$, on obtient un film isolant.

## Exemple 2

A partir de la poudre du complexe octadécylpyridinium-tétracyanoquinodiméthane (ODP-TCNQ) obtenu dans l'exemple 1, on forme et on transfère deux couches monomoléculaires de ce complexe sur un support isolant en quartz hydrophobe, en opérant dans les mêmes conditions que celles de l'exemple 1 et en déposant les couches par descente puis remontée du support en quartz. Le film obtenu est bleuté et sa résistivité est de 24 ohms.cm à 20 °C. Il comprend un seul plan hydrophile conducteur double.

## Exemple 3

Dans cet exemple, on forme un film conducteur en utilisant le premier mode de mise en œuvre du procédé mais en déposant alternativement sur un support isolant en verre des couches monomoléculaires d'un complexe à transfert de charge conducteur de l'électricité et des couches monomoléculaires d'un composé organique amphiphile isolant.

On prépare tout d'abord une solution de chloroforme contenant $5.10^{-4}$ $mol.l^{-1}$ d'acide béhénique et on la disperse sur la surface de l'eau distillée d'une cuve de Langmuir. On comprime ensuite la couche à 35 mN/m et on la dépose sur le support isolant. On prépare alors une solution de chloroforme contenant $5.10^{-4}$ $mol.l^{-1}$ du complexe ODP-TCNQ de l'exemple 1 ; on disperse cette solution sur l'eau de la cuve de Langmuir et on comprime les couches monomoléculaires à une pression de 26 mN/m. On dépose ainsi deux couches monomoléculaires de ce complexe sur le support isolant revêtu de la couche d'acide béhénique. On dépose ensuite de la même façon deux couches monomoléculaires d'acide béhénique et deux couches monomoléculaires du complexe amphiphile ODP-TCNQ.

On obtient ainsi un film conducteur de l'électricité dans le plan, ayant une résistivité de 10 ohms.cm à 20 °C. Ce film présente une très grande anisotropie entre la résistivité perpendiculaire au plan et la résistivité parallèle au plan ; l'anisotropie est supérieure à 10.

Exemple 4

Dans cet exemple, on utilise le second mode de mise en œuvre du procédé pour fabriquer un film conducteur de docosylpyridinium-tétracyanoquinodiméthane (DCP-TCNQ).

On prépare tout d'abord le complexe amphiphile DCP-TCNQ par métathèse à partir de l'iodure de docosylpyridinium et du sel de lithium de TCNQ.

On lave le complexe obtenu et on le recristallise. La poudre bleue du complexe ainsi obtenu n'est pas conductrice. On solubilise cette poudre dans un mélange de chloroforme et d'alcool (5 % alcool en volume) pour obtenir une solution contenant $5.10^{-4}$ mol.$l^{-1}$ du complexe, et on forme sur la surface d'une cuve de Langmuir remplie d'eau distillée une couche monomoléculaire que l'on comprime à une pression de 36 mN/m. On transfère ensuite cette couche sur un support isolant en $CaF_2$ qui a été recouvert préalablement de trois couches monomoléculaires d'acide béhénique en suivant le mode opératoire de l'exemple 3. On dépose ainsi sur ce support dix huit couches du complexe amphiphile DCP-TCNQ.

Le film bleu ainsi obtenu est isolant. Par diffusion d'iode pendant une minute à 20 °C, on provoque une réorganisation des couches qui rend le film violet et conducteur. La distance entre les plans hydrophiles mesurée aux rayons X est alors de 48 Å et la résistivité de la partie conductrice du film est de 20 ohms.cm à 20 °C.

Exemple 5

Dans cet exemple, on utilise également le second mode de mise en œuvre du procédé pour préparer un film conducteur.

On part de la même poudre de DCP-TCNQ non conductrice que dans l'exemple 4 et on dépose dans les mêmes conditions que celles de l'exemple 4 deux couches monomoléculaires de ce complexe sur un support isolant en $CaF_2$ qui a été préalablement recouvert d'une couche d'acide béhénique en suivant le même mode opératoire que dans l'exemple 4. Dans ce cas, les parties actives des deux couches monomoléculaires du complexe à transfert de charge sont adjacentes. On traite alors le film isolant pendant 1 min par de l'iode à 20 °C. Le film devient violet pâle et progressivement conducteur. La résistivité de ce plan conducteur unique double est de 90 ohms.cm à 20 °C.

Exemple 6

Dans cet exemple, on utilise le troisième mode de mise en œuvre du procédé pour obtenir un film conducteur. Dans ce cas, on part de deux poudres purifiées, l'une constituée par le complexe ODP-TCNQ semiconducteur de l'exemple 1, l'autre étant de l'iodure d'octadécylpyridinium (ODP) isolant.

On forme alors sur la surface d'une cuve de Langmuir séparée en deux compartiments par une paroi verticale, une couche monomoléculaire du complexe ODP-TCNQ dans l'un des compartiments et une couche monomoléculaire d'iodure de ODP dans l'autre compartiment, en utilisant dans les deux cas une solution de chloroforme contenant $5.10^{-4}$ mol.$l^{-1}$ de complexe ODP-TCNQ ou d'iodure de ODP. On comprime la couche monomoléculaire de ODP-TCNQ à 26 mN/m et la couche monomoléculaire d'iodure d'octadécylpyridinium (ODP) à 30 mN/m, et on transfère alternativement sur un support isolant en $CaF_2$ une couche du complexe ODP-TCNQ et une couche d'iodure de ODP. On soumet ensuite le film ainsi obtenu, à un traitement thermique à 45 °C pendant 5 min et l'on obtient alors un film dont le spectre IR est caractéristique non plus d'un semiconducteur mais d'un conducteur organique.

Exemple 7

Dans cet exemple, on utilise le premier mode de mise en œuvre du procédé et le deuxième mode de mise en œuvre du procédé pour déposer sur un support isolant des séquences alternées de couches de complexes à transfert de charge de nature différente.

On dépose tout d'abord sur un support isolant recouvert d'une couche monomoléculaire d'acide béhénique deux couches du complexe DCP-TCNQ de l'exemple 4, en utilisant les mêmes conditions que celles de l'exemple 4 pour le dépôt d'acide béhénique et pour le dépôt du complexe. On traite ensuite par l'iode les couches ainsi obtenues comme dans l'exemple 4. On obtient ainsi un plan double conducteur ayant les mêmes caractéristiques que celui obtenu dans l'exemple 4. On dépose ensuite sur le même support deux couches d'acide béhénique dans les mêmes conditions que celles de l'exemple 4, puis deux couches monomoléculaires du complexe de l'exemple 1 (ODP-TCNQ) dans les conditions de l'exemple 1.

Le film ainsi obtenu présente une conductivité deux fois plus grande que dans les exemples 1 et 4, et des propriétés spectrales différentes de celles des complexes isolés.

Exemple 8

Dans cet exemple, on utilise le premier mode de mise en œuvre du procédé pour préparer un film constitué de couches monomoléculaires de 4-7 didocosyl, 1-10 phénanthroline-tétracyanoquinodiméthane.

On synthétise tout d'abord le complexe à transfert de charge en faisant réagir dans de l'acétonitrile 2 mmol de 4-7 didocosyl, 1-10 phénanthroline avec 3 mmol de tétracyanoquinodiméthane et 1 mmol de dihydrotétracyanoquinodiméthane ($TCNQH_2$). On précipite ainsi un complexe noir répondant à la formule :

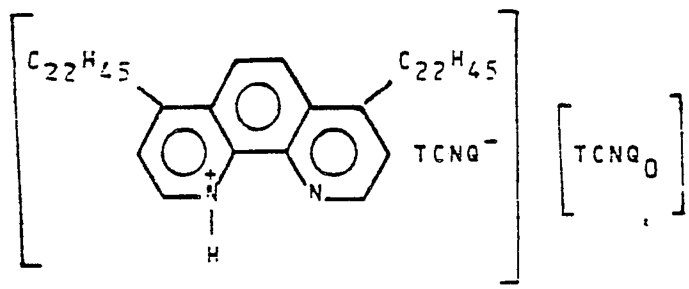

Par spectrométrie infrarouge on vérifie que ce complexe est conducteur de l'électricité. La stoechiométrie du complexe noir obtenue par dosage spectrophotométrique dans le visible d'une solution d'acétonitrile est caractéristique de la formule donnée ci-dessus.

On prépare alors une solution contenant $5.10^{-4}$ $mol.l^{-1}$ de ce complexe dans du chloroforme et on disperse cette solution sur la surface de l'eau d'une cuve de Langmuir. On forme ainsi une couche monomoléculaire que l'on comprime à une pression de 26 $mN.m^{-1}$ et on la transfère alors sur un support isolant en $CaF_2$ par la méthode de Langmuir Blodgett. On recommence plusieurs fois l'opération afin d'obtenir sur le support isolant un film comportant 19 couches monomoléculaires superposées, ce qui détermine 9 plans hydrophiles doubles conducteurs de l'électricité et un plan hydrophile simple conducteur de l'électricité.

Le film obtenu est conducteur de l'électricité et présente une résistivité de 10 $\Omega$.cm à 20 °C.

Exemple 9

Dans cet exemple, on utilise le premier mode de mise en œuvre du procédé pour préparer un film constitué de couches monomoléculaires de N-méthyl-4-octadécyl-5-octadécyloxyquinoléinium-tétracyanoquinodiméthane.

On synthétise tout d'abord le complexe en faisant réagir une solution dans l'acétonitrile d'iodure de N-méthyl-4-octadécyl-5-octadécyloxyquinoléinium, de tétracyanoquinodiméthanoate de lithium (LiTCNQ) et de TCNQ. On obtient ainsi un complexe conducteur de l'électricité répondant à la formule :

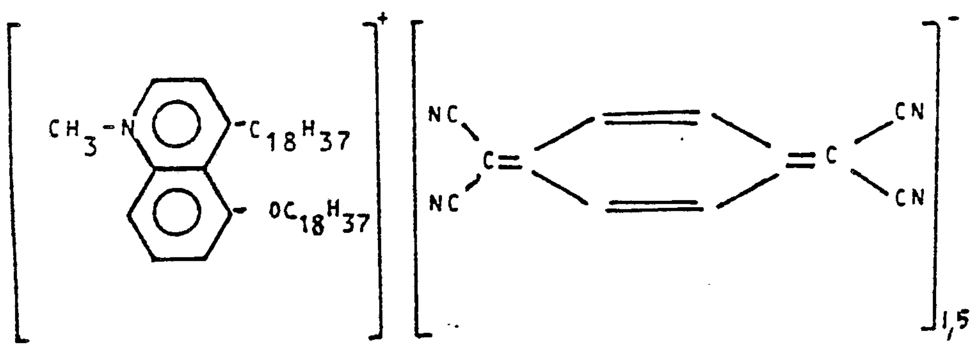

On prépare alors une solution contenant $5.10^{-4}$ $mol.l^{-1}$ de ce complexe dans du chloroforme et on disperse cette solution sur la surface de l'eau d'une cuve de Langmuir. On forme ainsi une couche monomoléculaire que l'on comprime à une pression de 35 $mN.m^{-1}$ et on la transfère alors sur un support isolant en $CaF_2$ par la méthode de Langmuir Blodgett. On recommence plusieurs fois l'opération afin d'obtenir sur le support isolant un film comportant 19 couches monomoléculaires superposées, ce qui détermine 9 plans hydrophiles doubles conducteurs de l'électricité et un plan hydrophile simple conducteur de l'électricité.

Le spectre infrarouge du film obtenu est caractéristique d'un matériau conducteur de l'électricité.

**Revendications**

1. Film conducteur de l'électricité présentant au moins une couche monomoléculaire de molécules amphiphiles d'un complexe organique à transfert de charge comportant au moins un groupe accepteur d'électrons et au moins un groupe donneur d'électrons, le groupe accepteur et/ou le groupe donneur d'électrons comportant au moins une chaîne hydrocarbonée de 16 à 30 atomes de carbone et les groupes

accepteurs et/ou donneurs d'électrons étant organisés de façon telle que deux groupes voisins de même nature, soit donneurs d'électrons, soit accepteurs d'électrons, puissent être suffisamment couplés dans le plan de la couche pour échanger un électron et assurer une conduction électrique dans ce plan.

2. Film selon la revendication 1, caractérisé en ce qu'il comprend plusieurs couches monomoléculaires superposées de molécules amphiphiles d'un complexe à transfert de charge, l'ensemble desdites couches déterminant dans le film des plans hydrophiles conducteurs de l'électricité séparés les uns des autres par les chaînes hydrocarbonées, hydrophobes, isolantes du complexe.

3. Film selon la revendication 1, caractérisé en ce qu'il comprend plusieurs couches monomoléculaires superposées, comprenant au moins une couche monomoléculaire de molécules amphiphiles d'un complexe à transfert de charge conducteur de l'électricité et au moins une couche monomoléculaire d'un composé amphiphile électriquement isolant, les différentes couches monomoléculaires étant disposées dans le film de façon telle qu'au moins deux des plans conducteurs formés dans deux couches monomoléculaires du complexe organique à transfert de charge conducteur soient séparés l'un de l'autre par une ou plusieurs couches monomoléculaires des molécules amphiphiles isolantes.

4. Film conducteur selon l'une quelconque des revendications 2 et 3, caractérisé en ce que les couches monomoléculaires conductrices de l'électricité sont réalisées à partir d'au moins deux complexes à transfert de charge conducteurs différents.

5. Film selon l'une quelconque des revendications 1 à 4, caractérisé en ce que le complexe organique à transfert de charge est un complexe de tétracyanoquinodiméthane.

6. Film selon la revendication 5, caractérisé en ce que le complexe est un alkylpyridinium-tétracyanoquinodiméthane.

7. Film selon l'une quelconque des revendications 3 et 4, caractérisé en ce que les molécules amphiphiles isolantes sont des molécules d'acide gras.

8. Film selon l'une quelconque des revendications 1 à 4, caractérisé en ce que le ou les complexes à transfert de charge conducteurs de l'électricité sont des complexes de formule $DA_xX_y$ dans laquelle D représente un groupe organique donneur d'électrons choisi parmi les bases aliphatiques, aromatiques et hétérocycliques, A représente un groupe organique accepteur d'électrons choisi parmi le tétracyanoéthylène (TCNE), l'hexacyanobutadiène (HCBD), le 1,2,4,5,-tétracyanobenzène (TCNB), le 7,7,8,8,-tétracyanoquinodiméthane (TCNQ) et ses dérivés substitués, le tétracyanodiquinodiméthane (TCNDQ), le benzotétracyanoquinodiméthane (benzo-TCNQ), le 2,3,5,6-tétrachloro-p-benzoquinone (CA), le trinitrobenzène (TNB), le tétranaphtoquinodiméthane (TNAP), le thiophénetétracyanoquinodiméthane (thiophène-TCNQ), le sélénophène-tétracyanoquinodiméthane (sélénophène-TCNQ), et le tétracyanoquinoquinazolinoquinazoline (TCQQ), X représente un accepteur d'électrons non amphiphile choisi parmi les acides de Lewis, x est un nombre supérieur à 0, et y est égal à 0 ou est un nombre supérieur à 0, l'un au moins des groupes D et A étant amphiphile et comportant au moins un substituant hydrocarboné saturé ou insaturé d'au moins 16 atomes de carbone.

9. Film selon la revendication 8, caractérisé en ce que le ou les complexes organiques à transfert de charge conducteurs de l'électricité sont des complexes de formule $DA_xX_y$ dans laquelle D représente un alkylpyrioinium, A représente le tétracyanoquinodiméthane (TCNQ) et X représente l'iode avec $1 < x \leqslant 2$ lorsque $y = 0$.

10. Procédé de préparation d'un film conducteur selon l'une quelconque des revendications 1 à 9, caractérisé en ce qu'il comprend les étapes suivantes :

a) déposer sur la surface d'un liquide polaire une solution d'un complexe à transfert de charge amphiphile conducteur de l'électricité de façon à former sur la surface dudit liquide une couche monomoléculaire,

b) comprimer la couche monomoléculaire ainsi formée à une pression supérieure à celle qui correspond à une transition de phase bidimensionnelle dudit complexe à transfert de charge, et

c) transférer le couche monomoléculaire ainsi comprimée sur un support.

11. Procédé selon la revendication 10, caractérisé en ce que le complexe à transfert de charge conducteur est l'octadécylpyridinium-tétracyanoquinodiméthane et en ce que l'on comprime la couche à une pression supérieure à 20 mN/m.

12. Procédé de fabrication d'un film selon l'une quelconque des revendications 1 à 9, caractérisé en ce qu'il comprend les étapes suivantes :

a) déposer sur un support isolant par la méthode de Langmuir Blodgett une ou plusieurs couches monomoléculaires d'un complexe organique à transfert de charge non conducteur de l'électricité, et

b) soumettre ensuite la ou les courbes monomoléculaires ainsi déposées à un traitement thermique et/ou chimique pour les rendre conductrices de l'électricité.

13. Procédé selon la revendication 12, caractérisé en ce que le traitement chimique consiste à diffuser de l'iode dans les couches monomoléculaires déposées sur le support.

14. Procédé selon la revendication 12, caractérisé en ce que le traitement thermique consiste à chauffer les couches ainsi déposées à une température inférieure à la température de fusion du complexe organique à transfert de charge.

15. Procédé de fabrication d'un film conducteur selon l'une quelconque des revendications 1 à 9, caractérisé en ce que l'on dépose sur un support des couches monomoléculaires de molécules amphiphiles d'un complexe organique à transfert de charge peu ou non conducteur de l'électricité et

d'un composé organique amphiphile capable de réagir avec le complexe à transfert de charge pour le rendre conducteur de l'électricité.

16. Procédé selon la revendication 15, caractérisé en ce que l'on dépose alternativement sur le support une couche monomoléculaire du complexe organique à transfert de charge non conducteur et une couche monomoléculaire du composé amphiphile.

17. Procédé selon la revendication 15, caractérisé en ce que l'on forme sur la surface d'un liquide une couche monomoléculaire de complexe organique à transfert de charge amphiphile non conducteur et du composé amphiphile et en ce que l'on dépose sur un support la couche monomoléculaire ainsi formée.

18. Procédé selon l'une quelconque des revendications 15 à 17, caractérisé en ce que le complexe à transfert de charge non conducteur de l'électricité est un alkylpyridinium tétracyanoquinodiméthane et le composé amphiphile est de l'iodure d'alkylpyridinium.

## Claims

1. Electricity-conducting film having at least one monomolecular layer of amphiphilic molecules of an organic charge transfer complex, comprising at least one electron acceptor group and at least one electron donor group, the electron acceptor and/or donor group having at least one hydrocarbon chain with 16 to 30 carbon atoms and the electron acceptor and/or donor groups are organized in such a way that two adjacent groups of the same type, namely electron donors or electron acceptors, can be sufficiently coupled in the plane of the layer to exchange an electron and ensure an electrical conduction in said plane.

2. Film according to claim 1, characterized in that it comprises several superimposed monomolecular layers of amphiphilic molecules of a charge transfer complex, all these layers defining in the film hydrophilic electricity conductor planes separated from one another by the insulating hydrophobic hydrocarbon chains of the complex.

3. Film according to claim 1, characterized in that it comprises several superimposed monomolecular layers having at least one monomolecular layer of amphiphilic molecules of an electricity-conducting charge transfer complex and at least one monomolecular layer of an electrically insulating amphiphilic compound, the different monomolecular layers being disposed in the film, in such a way that at least two conductor planes formed in two monomolecular layers of the organic conductive charge transfer complex are separated from one another by one or more monomolecular layers of insulating amphiphilic molecules.

4. Conducting film according to either of the claims 2 and 3, characterized in that the electricity-conducting monomolecular layers are formed at least two different conductive charge transfer complexes.

5. Film according to any one of the claims 1 to 4, characterized in that the organic charge transfer complex is a tetracyanoquinodimethane complex.

6. Film according to claim 5, characterized in that the complex is an alkyl pyridinium-tetracyanoquinodimethane.

7. Film according to either of the claims 3 and 4, characterized in that the insulating amphiphilic molecules are fatty acid molecules.

8. Film according to any one of the claims 1 to 4, characterized in that the electricity-conducting charge transfer complex or complexes are complexes of formula $DA_xX_y$, in which D represents an organic electron donor group chosen from among the aliphatic, aromatic and heterocyclic bases, A represents an organic electron acceptor group chosen from among tetracyanoethylene (TCNE), hexacyanobutadiene (HCBD), 1,2,4,5-tetracyanobenzene (TCNB), 7,7,8,8-tetracyanoquinodimethane (TCNQ) and its substituted derivatives, tetracyanodiquinodimethane (TCNDQ), benzotetracyanoquinodimethane (benzo-TCNQ), 2,3,5,6-tetrachloro-p-benzoquinone (CA), trinitrobenzene (TNB), tetranaphthoquinodimethane (TNAP), thiophenetetracyanoquinodimethane (thiophen-TCNQ), selenophen-tetracyanoquinodimethane (selenophen-TCNQ), and tetracyanoquinoquinazolinoquinazoline (TCQQ), X represents a non-amphiphilic electron acceptor chosen from among the Lewis 'acids, X is a number greater than 0 dans y is equal to 0 or is a umber greater than 0, at least one of the groups D and A being amphiphilic and having at least onf saturated or unsaturated hydrocarbon substituent with at least 16 carbon atoms.

9. Film according to claim 8, characterized in that the electricity-conducting, organic charge transfer complexes are complexes of formula $DA_xX_y$, in which D represents an alkyl pyridinium, A represents tetracyanoquinodimethane (TCNQ) and X represents iodine with $1 < x \leq 2$ when $y = 0$.

10. Process for the preparation of a conducting film according to any one of the claims 1 to 9, characterized in that it comprises the following stages :

a) depositing on the surface of a polar liquid a solution of an electricity-conducting, amphiphilic charge transfer complex so as to form a monomolecular layer on the surface of said liquid,

b) compressing the thus formed monomolecular layer at a pressure higher than that corresponding to a bidimensional phase transition of said charge transfer complex, and

c) transferring the thus compressed monomolecular layer to a support.

11. Process according to claim 10, characterized in that the conductive charge transfer complex is octadecyl pyridinium-tetracyanoquinodimethane and wherein the layer is compressed at a pressure exceeding 20 mN/m.

12. Process for producing a film according to any one of the claims 1 to 9, characterized in that it comprises the following stages :

a) depositing on an insulating support by the Langmuir Blodgett method one or more monomolecular layers of an organic, electricity-conducting charge transfer complex, and

b) then subjecting the thus deposited monomolecular layers or layer to a thermal or chemical treatment to make them electricity-conducting.

13. Process according to claim 12, characterized in that the chemical treatment consists of diffusing iodine into the monomolecular layers deposited on the support.

14. Process according to claim 12, characterized in that the thermal treatment consists of heating the thus deposited layers at a temperature below the melting temperature of the organic charge transfer complex.

15. Process for the production of a conducting film according to any one of the claims 1 to 9, characterized in that on a support are deposited monomolecular layers of amphiphilic molecules of an organic charge transfer complex which does not or only slightly conducts electricity and an amphiphilic organic compound able to react whith the charge transfer complex for making it electricity-conducting.

16. Process according to claim 15, characterized in that a monomolecular layer of the non-conducting organic charge transfer complex and a monomolecular layer of the amphiphilic compound are alternately deposited on the support.

17. Process according to claim 15, characterized in that on the surface of a liquid si formed a monomolecular layer of the organic, non-conducting, amphiphilic charge transfer complex and the amphiphilic compound and wherein the thus formed monomolecular layer is deposited on a support.

18. Process according to any one of the claims 15 to 17, characterized in that the non-electricity-conducting charge transfer complex is an alkyl pyridinium-tetracyanoquinodimethane and the amphiphilic compound is alkyl pyridinium iodide.

**Patentansprüche**

1. Elektrisch leitender Film, der mindestens eine monomolekulare Schicht von amphiphilen Molekülen eines organischen Ladungsübertragungskomplexes aufweist, der mindestens eine Elektronenakzeptorgruppe und mindestens eine Elektronendonorgruppe enthält, wobei die Elektronenakzeptorgruppe und/oder die Elektronendonorgruppe mindestens eine Kohlenwasserstoffkette mit 16 bis 30 Kohlenstoffatomen enthalten und die Elektronenakzeptorgruppen und/oder die Elektronendonorgruppen so angeordnet sind, daß zwei benachbarte Gruppen gleicher Art, entweder Elektronendonorgruppen oder Elektronenakzeptorgruppen, in der Ebene der Schicht ausreichend gekuppelt werden können, um ein Elektron auszutauschen und die elektrische Leitfähigkeit in dieser Ebene zu gewährleisten.

2. Film nach Anspruch 1, dadurch gekennzeichnet, daß er mehrere übereinander angeordnete monomolekulare Schichten von amphiphilen Molekülen eines Ladungsübertragungskomplexes aufweist, wobei die Gesamtheit dieser Schichten in dem Film elektrisch leitende hydrophile Ebenen bildet, die durch die elektrisch isolierenden, hydrophoben Kohlenwasserstoffketten des Komplexes voneinander getrennt sind.

3. Film nach Anspruch 1, dadurch gekennzeichnet, daß er mehrere übereinander angeordnete monomolekulare Schichten aufweist, die mindestens eine monomolekulare Schicht von amphiphilen Molekülen eines elektrisch leitenden Ladungsübertragungskomplexes und mindestens eine monomolekulare Schicht einer elektrisch isolierenden amphiphilen Verbindung umfassen, wobei die verschiedenen monomolekulare Schichten in dem Film so angeordnet sind, daß mindestens zwei der elektrisch leitenden Ebenen, die in zwei monomolekularen Schichten des elektrisch leitenden organischen Ladungsübertragungskomplexes gebildet werden, durch eine oder mehrere monomolekulare Schichten dieser elektrisch isolierenden amphiphilen Moleküle voneinander getrennt sind.

4. Film nach einem der Ansprüche 2 und 3, dadurch gekennzeichnet, daß die elektrisch leitenden monomolekularen Schichten aus mindestens zwei Ladungsübertragungskomplexen mit unterschiedlicher elektrischer Leitfähigkeit hergestellt sind.

5. Film nach einem der Ansprüche 1 bis 4, dadurch gekennzeichnet, daß es sich bei dem organischen Ladungsübertragungskomplex um einen Komplex von Tetracyanochinodimethan handelt.

6. Film nach Anspruch 5, dadurch gekennzeichnet, daß es sich bei dem Komplex um ein Alkylpyridinium-tetracyanochinodimethan handelt.

7. Film nach einem der Ansprüche 3 und 4, dadurch gekennzeichnet, daß es sich bei den elektrisch isolierenden amphiphilen Molekülen um Fettsäuremoleküle handelt.

8. Film nach einem der Ansprüche 1 bis 4, dadurch gekennzeichnet, daß es sich bei dem oder den elektrisch leitenden Ladungsübertragungskomplexen um Komplexe der Formel $DA_xX_y$ handelt, worin bedeuten D eine organische Elektronendonorgruppe, ausgewählt aus den aliphatischen aromatischen

und heterocyclischen Basen, A eine organische Elektronenakzeptorgruppe, ausgewählt aus Tetracyanoethylen (TCNE), Hexacyanobutadien (HCBD), 1,2,4,5-Tetracyanobenzol (TCNB), 7,7,8,8-Tetracyanochinodimethan (TCNQ) und seinen substituierten Derivaten, Tetracyanodichinodimethan (TCNDQ), Benzotetracyanochinodimethan (Benzo-TCNQ), 2,3,5,6-Tetrachloro-p-benzochinon (CA), Trinitrobenzol (TNB), Tetranaphthochinodimethan (TNAP), Thiophentetracyanochinodimethan (Thiophen-TCNQ), Selenophentetracyanochinodimethan (Selenophen-TCNQ) und Tetracyanochino-chinoazolinochinazolin (TCQQ), X einen nicht-amphiphilen Elektronenakzeptor, ausgewählt aus den Lewis-Säuren, x eine Zahl größer als 0 und y 0 oder eine Zahl größer als 0, wobei mindestens eine der Gruppen D und A amphiphil ist und mindestens einen gesättigten oder ungesättigten Kohlenwasserstoffsubstituenten mit mindestens 16 Kohlenstoffatomen enthält.

9. Film nach Anspruch 8, dadurch gekennzeichnet, daß der oder die elektrisch leitenden organischen Ladungsübertragungskomplexe Komplexe der Formel $DA_xX_y$ sind, worin bedeuten D ein Alkylpyridinium, A das Tetracyanochinodimethan (TCNQ) und X Jod, wobei $1 < x \leq 2$, wenn $y = 0$.

10. Verfahren zur Herstellung eines elektrisch leitenden Films nach einem der Ansprüche 1 bis 9, dadurch gekennzeichnet, daß es die folgenden Stufen umfaßt:

a) Aufbringen einer Lösung eines elektrisch leitenden amphiphilen Ladungsübertragungskomplexes auf die Oberfläche einer polaren. Flüssigkeit unter Ausbildung einer monomolekularen Schicht auf der Oberfläche der Flüssigkeit,

b) Komprimieren der so gebildeten monomolekularen Schicht bei einem Druck, der höher ist als derjenige, der einer bidimensionellen Phasenumwandlung des Ladungsübertragungskomplexes entspricht, und

c) Übertragen der so komprimierten monomolekularen Schicht auf einen Träger.

11. Verfahren nach Anspruch 10, dadurch gekennzeichnet, daß es sich bei dem elektrisch leitenden Ladungsübertragungskomplex um Octadecylpyridinium-tetracyanochinodimethan handelt und daß die Schicht bei einem Druck von höher als 20 mN/m komprimiert.

12. Verfahren zur Herstellung eines Films nach einem der Ansprüche 1 bis 9, dadurch gekennzeichnet, daß es die folgenden Stufen umfaßt:

a) Aufbringen einer oder mehrerer monomolekularer Schichten eines elektrisch nicht-leitenden organischen Ladungsübertragungskomplexes auf einen isolierenden Träger nach der Langmuir-Blodgett-Methode und

b) anschließendes thermisches und/oder chemisches Behandeln der so aufgebrachten monomolekularen Schicht(en), um sie elektrisch leitend zu machen.

13. Verfahren nach Anspruch 12, dadurch gekennzeichnet, daß die chemische Behandlung darin besteht, Jod in die auf den Träger aufgebrachten monomolekularen Schichten hineindiffundieren zu lassen.

14. Verfahren nach Anspruch 12, dadurch gekennzeichnet, daß die thermische Behandlung darin besteht, die auf diese Weise aufgebrachten Schichten auf eine Temperatur unterhalb der Schmelztemperatur des organischen Ladungsübertragungskomplexes zu erwärmen.

15. Verfahren zur Herstellung eineselektrisch leitenden Films nach einem der Ansprüche 1 bis 9, dadurch gekennzeichnet, daß man auf einen Träger aufbringt monomolekulare Schichten von amphiphilen Molekülen eines die Elektrizität wenig oder nicht leitenden organischen Ladungsübertragungskomplexes und einer amphiphilen organischen Verbindung, die mit dem Ladungsübertragungskomplex reagieren kann, um ihn elektrisch leitend zu machen.

16. Verfahren nach Anspruch 15, dadurch gekennzeichnet, daß man den Träger alternierend aufbringt eine monomolekulare Schicht eines elektrisch nicht-leitenden organischen Ladungsübertragungskomplexes und eine monomolekulare Schicht der amphiphilen Verbindung.

17. Verfahren nach Anspruch 15, dadurch gekennzeichnet, daß man auf der Oberfläche einer Flüssigkeit eine monomolekulare Schicht eines elektrisch nicht-leitenden amphiphilen organischen Ladungsübertragungskomplexes und der amphiphilen Verbindung bildet und daß man die so gebildete monomolekulare Schicht auf einen Träger aufbringt.

18. Verfahren nach einem der Ansprüche 15 bis 17, dadurch gekennzeichnet, daß es sich bei dem elektrisch nicht-leitenden Ladungsübertragungskomplex um ein Alkylpyridinium-tetracyanochinodimethan und bei der amphiphilen Verbindung um Alkylpyridiniumjodid handelt.